# EUROPÄISCHE PATENTANMELDUNG

(11) **EP 4 538 725 A1**
(43) Veröffentlichungstag der Anmeldung: **16.04.2025**
(21) Anmeldenummer: 23203152.6
(22) Anmeldetag: 12.10.2023
(51) Int. Cl.: G01R 31/367, G01R 31/374, G01R 31/392, G01R 31/36, H01M 10/48

(54) **ERMITTLUNG EINES LADEZUSTANDES UND/ODER EINES GESUNDHEITSZUSTANDES EINER BATTERIEZELLE**

(71) Anmelder: Siemens Aktiengesellschaft, 80333 München (DE)
(72) Erfinder: Arzberger, Arno, 96135 Stegaurach (DE); Fischer, Michael, 91320 Ebermannstadt (DE)
(74) Vertreter: Siemens Patent Attorneys

(57) **Zusammenfassung**

Es wird ein Verfahren zur Ermittlung eines Ladezustandes **SOC** und/oder eines Gesundheitszustandes **SOH** einer Batteriezelle mit einer nominellen Ladung *Q* vorgeschlagen, wobei die nominelle Ladung *Q* eine Ladung ***Q*₊** einer ersten Elektrode und eine Ladung ***Q*₋** einer zweiten Elektrode der Batteriezelle sowie eine inaktive Ladung ***Q*₀** der Batteriezelle umfasst. Das erfindungsgemäße Verfahren ist gekennzeichnet durch die Schritte:
- (S1) Bereitstellen eines ersten funktionalen Zusammenhangs ***V*(*Q*₊, *Q*₋)** für eine Ruhespannung der Batteriezelle;
- (S2) Bereitstellen eines zweiten funktionalen Zusammenhangs ***D*(*Q*₊, *Q*₋*, Q*₀)** für eine Ausdehnung der Batteriezelle;
- (S3) Erfassen eines Messwertes ***V*** der Ruhespannung;
- (S4) Erfassen eines Messwertes ***D*** der Ausdehnung; und
- (S5) Ermitteln des Ladezustandes **SOC** und/oder des Gesundheitszustandes **SOH** durch ein Lösen des Gleichungssystems ***V* = *V*(*Q*₊*, Q₋*)*, D* = *D*(*Q*₊*, Q₋, Q*₀)** und ***Q* = *Q*₊** + ***Q₋* + *Q*₀**.

Weiterhin betrifft die Erfindung ein Batteriemanagementsystem sowie eine Batteriezelle.

## Beschreibung

Die Erfindung betrifft ein Verfahren gemäß dem Oberbegriff des Patentanspruches 1, ein Batteriemanagementsystem gemäß dem Oberbegriff des Patentanspruches 13 sowie eine Batteriezelle oder eine Batterie gemäß dem Oberbegriff des Patentanspruches 14.

Eine möglichst genaue Ermittlung des Ladezustandes (englisch: State of Charge; SOC) und eines Alterungszustandes (englisch: State of Health; SOH) von Batterien, insbesondere von Lithium-Ionen-Batterien, ist entscheidend zur Beurteilung der Leistung und Einsatzmöglichkeiten der Batterien.

Ein typischer Alterungsmechanismus von Batterien beziehungsweise Batteriezellen ist der Verlust von elektrochemisch verfügbarer Ladung. Die Zunahme dieser elektrochemisch inaktiven Ladung führt dazu, dass sich der Gesundheitszustand beziehungsweise Alterungszustand der Batterie mit der Zeit verringert. Der zeitliche Verlauf des SOH ist typischerweise komplex sowie vom spezifischen Betrieb der Batterie und von einer Vielzahl von bezüglich der Batterie externen Einflüssen abhängig.

Typischerweise ist die Ermittlung des SOC und des SOH mittels während des Betriebs der Batterie zugänglichen Messgrößen unmittelbar nicht möglich. Hierzu werden somit komplexe und damit fehleranfällige beziehungsweise ungenaue Verfahren verwendet, die beispielsweise durch ein Batteriemanagementsystem bereitgestellt werden.

Typischerweise werden SOH und SOC mittels zeitlich abhängigen Messgrößen, beispielsweise Stromverläufen, Spannungsverläufen und gegebenenfalls Temperaturverläufen berechnet. Hierbei lassen sich über die zeitlich gemessenen Stromverläufe ebenfalls die Ladungen bestimmen, die zwischen den Elektroden der Batterie ausgetauscht werden.

Weiterhin können eine interne Selbstentladung und Nebenreaktionen einer Batterie nicht gemessen werden. Hinzu kommen Fehler durch die Messgenauigkeit, die sich bei längerer Dauer der Ladungsbestimmung aufsummieren können. Daher kann die gemessene Ladung nicht zur Bestimmung der tatsächlichen Ladungsänderung zwischen den Elektroden verwendet werden, was zu Fehlern beim ermittelten SOC beziehungsweise SOH führt.

Weitere bekannte Verfahren verwenden Messungen des internen Widerstands und der Temperatur, beispielsweise Methoden der Impedanzspektroskopie, und vergleichen die erfassten Messwerte mit Alterungsmodellen. Allerdings ist es hierbei ebenfalls wichtig in Kenntnis der aktuell in den Elektroden gespeicherten Ladung zu sein, da die genaue Zuordnung vom gemessenen Widerstandswert zum Modell hiervon abhängig ist.

Ferner ist eine Vielzahl von herstellerspezifischen approximativen und heuristischen Verfahren zur Ermittlung des SOC beziehungsweise SOH bekannt.

Der vorliegenden Erfindung liegt die Aufgabe zugrunde, ein verbessertes Verfahren zur Ermittlung des Ladezustandes und/oder Gesundheitszustandes einer Batteriezelle bereitzustellen, insbesondere während eines Betriebs der Batteriezelle.

Die Aufgabe wird durch ein Verfahren mit den Merkmalen des unabhängigen Patentanspruches 1, durch ein Batteriemanagementsystem mit den Merkmalen des unabhängigen Patentanspruches 13 sowie durch eine Batteriezelle oder eine Batterie mit den Merkmalen des unabhängigen Patentanspruches 14 gelöst. In den abhängigen Patentansprüchen sind vorteilhafte Ausgestaltungen und Weiterbildungen der Erfindung angegeben.

Das erfindungsgemäße Verfahren zur Ermittlung eines Ladezustandes **SOC** und/oder eines Gesundheitszustandes **SOH** einer Batteriezelle mit einer nominellen Ladung ***Q*** (nominelle Kapazität), wobei die nominelle Ladung ***Q*** eine Ladung ***Q*₊** einer ersten Elektrode und eine Ladung ***Q*₋** einer zweiten Elektrode der Batteriezelle sowie eine inaktive Ladung ***Q*₀** der Batteriezelle umfasst, ist wenigstens gekennzeichnet durch die folgenden Schritte:
- Bereitstellen eines ersten funktionalen Zusammenhangs *V*(*Q*₊, *Q₋*) für eine Ruhespannung der Batteriezelle;
- Bereitstellen eines zweiten funktionalen Zusammenhangs *D*(*Q*₊, *Q₋, Q*₀) für eine Ausdehnung der Batteriezelle;
- Erfassen eines Messwertes ***V*** der Ruhespannung;
- Erfassen eines Messwertes ***D*** der Ausdehnung; und
- Ermitteln des Ladezustandes **SOC** und/oder des Gesundheitszustandes **SOH** durch ein Lösen des Gleichungssystems ***V* =** *V*(*Q*₊, ***Q₋*)*, D* =** *D*(*Q*₊, *Q₋,* ***Q*₀)** und ***Q* = *Q*₊ + *Q*₋ +** *Q*₀.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt sein. Insbesondere kann das Lösen des Gleichungssystems numerisch mittels einer Recheneinheit, beispielsweise einem Computer, erfolgen. Hierbei ist ein exaktes Lösen des Gleichungssystems nicht erforderlich, sondern es genügt einer exakten Lösung möglichst nahe zu kommen, beispielsweise bis zu einer festgelegten Fehlerschranke.

Die Reihenfolge der Schritte des Verfahrens impliziert keine zeitliche Abfolge der genannten Schritte. Beispielsweise kann das Erfassen der Messwerte und/oder das Bereitstellen der funktionalen Zusammenhänge zeitlich parallel erfolgen.

Merkmale, Ausgestaltungen und/oder Ausführungsbeispiele bezüglich des Ladezustandes sind unmittelbar und eindeutig in analogerweise auf den Gesundheitszustand übertragbar.

Grundsätzlich können alle genannten Größen und Abhängigkeiten zeitabhängig sein.

Die Ausdehnung der Batteriezelle kann eine absolute räumliche Ausdehnung der Batteriezelle, beispielsweise in einer räumlichen Richtung, eine relative Ausdehnung bezüglich einer ursprünglichen beziehungsweise initialen Ausdehnung der Batteriezelle (Differenzwert zur ursprünglichen Ausdehnung), eine auf eine ursprünglich beziehungsweise initiale Ausdehnung der Batteriezelle normierte Ausdehnung und/oder eine relative Änderung der räumlichen absoluten Ausdehnung der Batteriezelle bezüglich einer ursprünglichen beziehungsweise initialen Ausdehnung der Batteriezelle (Differenzenquotient) sein. Insbesondere ist die Ausdehnung ein auf ein ursprüngliches Volumen normiertes Volumen.

Unter einem funktionalen Zusammenhang kann die mathematische Möglichkeit verstanden werden, aus einem Wert einer oder mehrerer Größen auf den Wert einer oder mehrerer weiterer Größen zu schließen. Ein funktionaler Zusammenhang kann beispielsweise in Form einer Funktion, insbesondere einer Fitfunktion, einer Tabelle und/oder in Form eines Graphens/Diagramms vorliegen.

Der erste funktionale Zusammenhang beschreibt beziehungsweise modelliert die Abhängigkeit der Ruhespannung *V*(*Q*₊, *Q₋*) der Batteriezelle von den Ladungen der Elektroden ***Q*₊*, Q₋.***

Der zweite funktionale Zusammenhang beschreibt beziehungsweise modelliert die Abhängigkeit der Ausdehnung der Batteriezelle *D*(*Q*₊, *Q₋, Q*₀) von den Ladungen der Elektroden *Q₊, Q₋* sowie der vorhandenen inaktiven Ladung ***Q*₀.**

Die Batteriezelle umfasst die erste und zweite Elektrode, die ebenfalls als positive Elektrode beziehungsweise negative Elektrode bezeichnet werden können. Grundsätzlich ist mit jeder Elektrode eine Ladung beziehungsweise eine Kapazität assoziiert. Weist die Batterie die nominelle Ladung ***Q*** auf, so umfasst diese die Ladungen der Elektroden ***Q*₊*, Q*₋** sowie mögliche inaktive Ladungen ***Q*₀,** beispielsweise aufgrund des Alters der Batteriezelle. Die Ladung ***Q*** ist die nominelle spezifizierte Kapazität der Batteriezelle zu Beginn ihrer Lebensdauer und somit vorab, beispielsweise durch eine Herstellerangabe, bekannt.

Ein Grundgedanke der vorliegenden Erfindung ist, dass der Ladezustand und/oder der Gesundheitszustand ermittelt werden kann, wenn die Ladungen ***Q*₊*, Q*₋** sowie gegebenenfalls ***Q*₀** bekannt sind. Allerdings sind die genannten Ladungen nicht unmittelbar messbar. Erfindungsgemäß ist jedoch vorgesehen, die Ladungen mittels messtechnisch erfassbaren Größen, vorliegend die Ruhespannung und die Ausdehnung der Batteriezelle, zu ermitteln. Als ein dritter funktionaler Zusammenhang wird hierbei die Ladungserhaltung *Q* = *Q*₊ + *Q₋* + *Q*₀ verwendet.

Mit anderen Worten ist es vorgesehen ein Gleichungssystem aufzustellen, mittels welchem die Ladungen basierend auf Messgrößen ermittelt werden können. Sind die Ladungen dadurch ermittelt beziehungsweise deren Werte berechnet, kann der Ladezustand und/oder Gesundheitszustand der Batteriezelle ermittelt werden.

Für das Ermitteln der drei Ladungen sind somit grundsätzlich drei Zusammenhänge sowie drei Messgrößen erforderlich. Die drei Zusammenhänge werden erfindungsgemäß durch die Zusammenhänge *V* **=** *V*(*Q*₊, *Q₋*)*, D* **=** *D*(*Q*₊*, Q₋, Q*₀) und *Q* = *Q*₊ + *Q*₋ + *Q*₀ ausgebildet. Die drei Messgrößen sind die Ruhespannung ***V*,** die Ausdehnung ***D*** und die bereits vorab bekannte nominelle Ladung ***Q*** der Batteriezelle, die ergänzend ebenfalls mittels einer Messung erfasst werden könnte. Durch das Lösen des genannten Gleichungssystems mit den drei Unbekannten *Q*₊*, Q₋* und *Q*₀ können somit die Ladungen ermittelt werden. Hierbei werden die funktionalen Zusammenhänge bereitgestellt, das heißt diese sind vorab bekannt. Beispielsweise können diese durch Messungen in Form von Kennlinien vorab bestimmt werden. Die Kennlinien können für einen spezifischen Typ der Batteriezelle im Vorfeld beispielsweise durch Messungen und/oder Simulationen der jeweiligen Elektroden, Nebenreaktionen und Zellen bestimmt werden. Dadurch sind die Kennlinien im Betrieb und für das erfindungsgemäße Verfahren bekannt.

Durch die vorliegende Erfindung kann somit durch die Ermittlung der unbekannten und messtechnisch nicht unmittelbar zugänglichen Ladungen der Ladezustand beziehungsweise der Gesundheitszustand der Batteriezelle ermittelt werden. Hierbei werden zeitlich aktuelle Messwerte der Ruhespannung, der Ausdehnung sowie der vorab bekannte Wert der nominellen Ladung (Kapazität) der Batteriezelle verwendet. Dadurch ist insbesondere eine Ermittlung des **SOC** und/oder des **SOH** im beziehungsweise während des Betriebs der Batteriezelle möglich. Mit anderen Worten werden die Ladungen mittels Messungen von ***V*** und ***D*** zum aktuellen Betriebszeitpunkt bestimmt, wodurch der aktuelle **SOC** und/oder **SOH** ermittelt werden können.

Hierbei ist ein weiterer Grundgedanke der Erfindung, dass als weiterer erforderlicher Zusammenhang die messbare Ausdehnung der Batteriezelle verwendet wird. Die Ausdehnung ist insbesondere deshalb von besonderem Vorteil, da diese ebenfalls von der inaktiven Ladung abhängig ist.

Weiterhin ist die Verwendung der Ausdehnung besonders für Lithium-Ionen-Zellen mit einer erhöhten Energiedichte vorteilhaft. Das ist deshalb der Fall, da deren negative Elektroden typischerweise anteilig Silizium umfassen. Das Material Silizium weist bereits bei geringen Mengen eine große Volumenänderung (Ausdehnung) abhängig von der aufgenommenen Ladung auf. Dadurch ist die Ausdehnung, vorliegend im Sinne einer Änderung des Volumens, messtechnisch ausreichend genau erfassbar.

Auch die nächsten Generationen von Batterien beziehungsweise Batteriezellen, beispielsweise basierend auf Festkörper Elektrolyten und/oder metallischem Lithium und/oder Natrium, sowie solche basierend auf der Interkalation von Natriumionen, weisen vergleichsweise große Volumenänderungen auf, die im Sinne der vorliegenden Erfindung als Ausdehnung herangezogen werden können.

Bisherige Lithium-Ionen-Zellen verwenden typischerweise Interkalationselektroden mit geringer Volumenausdehnung. Dennoch kann ebenfalls in diesem Fall die Ausdehnung der Graphitelektrode beim Laden der Batteriezelle gemessen werden.

Weiterhin können Nebenreaktionen innerhalb der Batteriezelle, die typischerweise zu einem Anwachsen der inaktiver Ladungen führen, eine Volumenveränderung induzieren und somit einen Einfluss auf die (aktuelle) Ausdehnung der Batteriezelle aufweisen. Hierbei sei exemplarisch die kontinuierliche Weiterbildung der Solid-Electrolyte-Interface (SEI) Schicht genannt.

Eine implizite Annahme des erfindungsgemäßen Verfahrens ist, dass die funktionalen Zusammenhänge beziehungsweise Abhängigkeiten, beispielsweise in Form von Kennlinien, der relevanten Materialien der Batteriezelle bekannt sind und sich nicht Wesentlich während der Alterung verändern. Dies gilt grundsätzlich ebenfalls für Elektroden, die aus mehreren Komponenten/Materialen zusammengesetzt sind. Beispielsweise kann die negative Elektrode Grafit und Silizium umfassen. Allerdings kann ein Verlust von Elektrodenmaterial, beispielsweise dadurch, dass Partikel den elektrischen Kontakt zum Rest der Elektrode verlieren, die relativen Anteile von positiver zu negativer Elektrode, und/oder auch die relativen aktiven Bestandteile innerhalb einer Elektrode, verändern, was auch eine Änderung der angenommenen und bereitgestellten Spannungs- und/oder Ausdehnungskennlinien bedeuten würde. Auch das Auftreten von weiteren Nebenreaktionen, die gegebenenfalls in den funktionalen Zusammenhängen nicht berücksichtigt wurden, können grundsätzlich die ermittelten Werte verfälschen.

Die vorliegende Erfindung stellt jedoch gegenüber dem genannten Stand der Technik ein robusteres Verfahren zur Ermittlung des **SOC** und/oder des **SOH** bereit. Das Verfahren basiert hierbei auf zu jedem Zeitpunkt des Betriebs der Batteriezelle messbaren physikalischen Größen. Zudem erfordert das Verfahren keine komplexe Modelle und/oder Berechnungen. Insbesondere ist keine Berechnung von Ladungsverschiebungen durch zeitliche Integration von Stromverläufen (englisch: Coulomb Counting) erforderlich.

Ein erfindungsgemäßes Batteriemanagementsystem für eine Batteriezelle ist dadurch gekennzeichnet, dass dieses ausgebildet ist, einen Ladezustand und/oder Gesundheitszustand der Batteriezelle nach einem Verfahren gemäß der Erfindung und/oder einer ihrer Ausgestaltungen zu ermitteln.

Hierzu kann das Batteriemanagementsystem eine erste Messeinrichtung zur Erfassung der Ruhespannung, eine zweite Messeinrichtung zur Erfassung der Ausdehnung, beispielsweise ein Dilatometer, sowie eine Recheneinheit zum Lösen des Gleichungssystems und zum Ermitteln des Ladezustandes und/oder des Gesundheitszustandes umfassen.

Hierbei können die funktionalen Zusammenhänge mittels der Recheneinheit abgespeichert und somit bereitgestellt sein.

Es ergeben sich zum erfindungsgemäßen Verfahren gleichartige, gleichwertige und gleichwirkende Vorteile und/oder Ausgestaltungen des erfindungsgemäßen Batteriemanagementsystems.

Eine erfindungsgemäße Batteriezelle oder Batterie, ist dadurch gekennzeichnet, dass diese ein erfindungsgemäßes Batteriemanagementsystem umfasst.

Es ergeben sich zum erfindungsgemäßen Verfahren sowie zum erfindungsgemäßen Batteriemanagementsystem gleichartige, gleichwertige und gleichwirkende Vorteile und/oder Ausgestaltungen der erfindungsgemäßen Batteriezelle beziehungsweise Batterie.

Gemäß einer vorteilhaften Ausgestaltung der Erfindung werden zum Ermitteln des Ladezustandes **SOC** und/oder des Gesundheitszustandes **SOH** die Ladungen *Q*₊*, Q₋* und/oder *Q*₀ durch ein Lösen des Gleichungssystems *V* = *V*(*Q*₊*, Q*₋)*, D*(*Q*₊*, Q₋, Q*₀) und *Q* = *Q*₊ + *Q₋* + ***Q*₀** ermittelt.

Dadurch sind vorteilhafterweise die Ladungen bekannt. Aus den bekannten Ladungen kann der Ladezustand beziehungsweise der Gesundheitszustand ermittelt werden. Grundsätzlich kann äquivalent der **SOC** und/oder **SOH** direkt als Variable verwendet werden, sodass ein explizites Ermitteln der Ladungen nicht für das erfindungsgemäße Verfahren erforderlich, jedoch vorteilhaft ist.

In einer vorteilhaften Weiterbildung der Erfindung wird der Ladezustand **SOC** mittels SOC = *Q₋*/(*Q*₊ + *Q*₋) ermittelt.

Dadurch wird ein vorteilhafter Ladezustand der Batteriezelle ermittelt. Insbesondere bezieht sich der genannte Ladezustand auf den Ladezustand der negativen Elektrode.

Gemäß der vorliegenden Erfindung wird ein Ladezustand der Batteriezelle ermittelt, das heißt es gibt mehrere mögliche technisch sinnvolle Definitionen des Ladezustandes. Beispielsweise kann sich der Ladezustand durch SOC = *Q₋*/(*Q*₊ + *Q*₋) ≡ SOC₋ auf die negative Elektrode oder durch SOC = *Q*₊/(*Q*₊ + *Q₋*) ≡ **SOC₊** auf die positive Elektrode beziehen. Hierbei sei angemerkt, dass der nicht auf eine Komponente bezogene Ladezustand einer Batteriezelle keine über die Lebensdauer feste Abhängigkeit von der Ausdehnung aufweist. Somit wird im Rahmen der vorliegenden Erfindung als der Ladezustand der Batteriezelle stets der Ladezustand einer Komponente der Batteriezelle, insbesondere einer der Elektroden, verstanden. Hierbei ist der Ladezustand der Batteriezelle, die normierte mittels der jeweiligen Komponente, insbesondere Elektrode, gespeicherte Ladung.

Äquivalent und ebenfalls durch die Erfindung umfasst, ist ein Verwenden von SOC₊ und SOC₋ anstatt von *Q*₊ beziehungsweise *Q*₋ als Variablen des zu lösenden Gleichungssystems. Weitere in diesem Sinne mathematisch zu den Ladungen äquivalente Variablen können vorgesehen sein.

Gemäß einer vorteilhaften Ausgestaltung der Erfindung wird ein Gesundheitszustand **SOH** der Batteriezelle durch **SOH = (*Q*₊ + *Q*₋)/*Q*** ermittelt, das heißt mittels den Ladungen beziehungsweise mittels den Ladungsmengen.

Vorteilhafterweise wird dadurch der State of Health (**SOH**) der Batteriezelle ermittelt. Insbesondere wird dadurch der **SOH** ohne ein zyklisches Laden und Entladen der Batteriezelle ermittelt. Dadurch kann der **SOH,** wie bereits der **SOC,** vorteilhafterweise während des Betriebs der Batteriezelle ermittelt werden.

In einer vorteilhaften Weiterbildung der Erfindung wird eine Änderungsrate des Gesundheitszustandes **SOH** ermittelt, und mittels der Änderungsrate eine Alterung beziehungsweise Alterungsrate des Batteriezelle bestimmt.

Die zeitliche Änderungsrate des **SOH** kann beispielsweise durch ein zeitlich mehrmaliges Ermitteln des **SOH** erfolgen. Mit anderen Worten wird das Verfahren mehrmals zeitlich hintereinander durchgeführt. Durch diese wiederholte Bestimmung des **SOH** und gegebenenfalls analog des **SOC** kann somit die möglicherweise komplexe und zeitlich nichtlineare Änderungsrate des **SOH** ermitteln. Dadurch wird vorteilhafterweise eine Prognose über das Alterungsverhalten der Batterie möglich.

Gemäß einer vorteilhaften Ausgestaltung der Erfindung wird der erste funktionale Zusammenhang durch *V*(*Q*₊, *Q₋*) = *V*₊(*Q*₊) *-* ***V*₋(*Q*₋)** bereitgestellt, wobei ***V*₊(*Q*₊)** eine Spannungskennlinie der ersten Elektrode und ***V*₋(*Q*₋)** eine Spannungskennlinie der zweiten Elektrode ist.

Mit anderen Worten wird der erste funktionale Zusammenhang durch zwei Spannungskennlinien bereitgestellt. Hierbei ergibt sich die Kennlinie für die Ruhespannung aus der Potentialdifferenz zwischen den beiden Elektroden. Die Kennlinien können vorab bestimmt werden, und beispielsweise innerhalb des Batteriemanagementsystems gespeichert vorliegen und somit bereitgestellt werden.

In einer vorteilhaften Weiterbildung der Erfindung wird der zweite funktionale Zusammenhang durch *D*(*Q*₊, *Q₋, Q*₀) = *D*₊(*Q*₊) + *D₋*(*Q₋*) + *Dₒ*(*Qₒ*) bereitgestellt, wobei ***D*₊(*Q*₊)** eine Ausdehnungskennlinie der ersten Elektrode, *D*₋(*Q*₋) eine Ausdehnungskennlinie der zweiten Elektrode und ***Dₒ*(*Qₒ*)** eine Ausdehnungskennlinie bezüglich der inaktiven Ladung ***Q*₀** ist.

Mit anderen Worten ist die (Gesamt-)Ausdehnung der Batteriezelle die Summe der Ausdehnung bezüglich der jeweiligen Ladungen. Somit ist mit jeder Ladung eine ladungsspezifische Ausdehnung assoziiert. Die Ausdehnungskennlinien *D*₊(*Q*₊)*, D*₋(*Q*₋) und *D*₀(*Q*₀) sind abhängig von der chemischen und strukturellen Zusammensetzung der jeweiligen Elektroden beziehungsweise Materialien/Komponenten. Sie sind somit grundsätzlich ebenfalls von der Temperatur der Batteriezelle abhängig, sodass zusätzlich eine temperaturabhängige Korrektur der Kennlinien vorteilhaft ist. Die Kennlinien sowie ihre mögliche Temperaturabhängigkeit beziehungsweise temperaturabhängige Korrektur können wiederum vorab bestimmt werden, und beispielsweise innerhalb des Batteriemanagementsystems gespeichert vorliegen und somit bereitgestellt werden.

Gemäß einer vorteilhaften Ausgestaltung der Erfindung wird somit eine Temperatur der Batteriezelle erfasst, wobei die jeweiligen Kennlinien die Abhängigkeit von der erfassten Temperatur berücksichtigen.

Dadurch kann vorteilhafterweise eine Temperaturkorrektur erfolgen, sodass der **SOC** und/oder **SOH** genauer, insbesondere während des Betriebs der Batteriezelle, ermittelt werden können. Somit wird die Temperatur, beispielsweise ergänzend zur Spannung, zum Strom und zur Ausdehnung, als weitere Messgröße verwendet.

In einer vorteilhaften Weiterbildung der Erfindung werden die Kennlinien in Abhängigkeit der jeweiligen Stoffzusammensetzung, insbesondere der Elektroden, bereitgestellt.

Dadurch berücksichtigen die Kennlinien vorteilhafterweise die materialspezifische Zusammensetzung der Elektroden und somit der Batteriezelle.

Gemäß einer vorteilhaften Ausgestaltung der Erfindung werden die Kennlinien in Abhängigkeit des Typs der Batteriezelle bereitgestellt.

Dadurch wird vorteilhafterweise die Ermittlung des SOC weiter verbessert, da der spezifische Batterietyp berücksichtigt ist.

In einer vorteilhaften Weiterbildung der Erfindung wird der Messwert ***D*** der Ausdehnung mittels eines Dilatometers, einer Kraftmessung, einer Druckmessung und/oder mittels Dehnungsmessstreifen erfasst.

Vorteilhafterweise ermöglichen die genannten Messverfahren eine besonders genaue Ermittlung der Ausdehnung. Zudem sind die genannten Messverfahren vorteilhafterweise während des Betriebes der Batteriezelle möglich. Gemäß den genannten Messverfahren kann die Ausdehnung somit direkt oder indirekt ermittelt und somit erfasst werden.

Gemäß einer vorteilhaften Ausgestaltung der Erfindung erfolgt die Ermittlung des Ladezustandes **SOC** und/oder des Gesundheitszustandes **SOH** während eines Betriebs der Batteriezelle.

Dadurch ist vorteilhafterweise eine Unterbrechung des Betriebes der Batteriezelle, wie beispielsweise bei bekannten Verfahren, nicht erforderlich. Die vorliegende Erfindung ermöglicht durch Verwendung von während des Betriebs zugänglich und erfassbaren Messwerten (Ruhespannung und Ausdehnung) vorteilhafterweise das Ermitteln des **SOC** während des Betriebs.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
Figur 1 ein Ablaufdiagramm eines Verfahrens gemäß einer Ausgestaltung der Erfindung;
Figur 2 eine erste Kennlinie bezüglich einer Ausdehnung einer Batteriezelle; und
Figur 3 eine zweite Kennlinie bezüglich einer Ausdehnung einer Batteriezelle.

Gleichartige, gleichwertige oder gleichwirkende Elemente können in einer der Figuren oder in den Figuren mit denselben Bezugszeichen versehen sein.

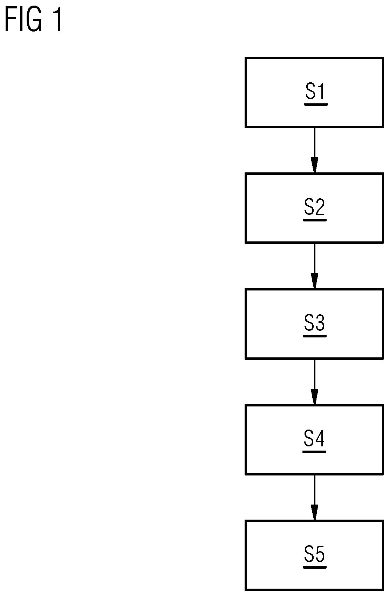

Die Figur 1 zeigt ein Ablaufdiagramm eines Verfahrens zur Ermittlung eines Ladezustandes **SOC** und/oder eines Gesundheitszustandes **SOH** einer Batteriezelle gemäß einer Ausgestaltung der Erfindung.

Die Batteriezelle weist eine nominelle Ladung ***Q*** auf. Hierbei ist typischerweise die nominelle Ladung ***Q*** der Batteriezelle mittels einer positiven und negativen Elektrode beziehungsweise mittels einer ersten und zweiten Elektrode der Batteriezelle gespeichert, oder geht, beispielsweise aufgrund einer Alterung in elektrochemisch inaktiver Form verloren. Somit ist ***Q* = *Q*₊ + *Q₋* + *Q*₀,** wobei ***Q*₀** die elektrochemisch inaktive Ladung bezeichnet. Die nominelle Ladung beziehungsweise nominelle Kapazität ist typischerweise bekannt oder kann zu Anfang der Lebensdauer der Batteriezelle messtechnisch erfasst werden.

Ein Alterungszustand der Batteriezelle kann mittels **SOH = *Q*ₘₐₓ/*Q*** ermittelt werden, wobei ***Q*ₘₐₓ** die maximale speicherbare elektrische Ladung der Batteriezelle zu einem aktuellen Zeitpunkt ist, und *Q* die nominell spezifizierte Kapazität zu Beginn der Lebensdauer der Batteriezelle bezeichnet.

Ein Ladezustand der Batteriezelle kann mittels SOC = *Q*/*Q*ₘₐₓ ermittelt werden.

Die maximal speicherbare Ladung entspricht den elektrochemisch aktiven Anteilen, sodass ***Q*ₘₐₓ** = ***Q*₊** + ***Q₋*** ist. Weiterhin entspricht die aktuell gespeicherte Ladung der Ladung der negativen Elektrode, sodass ***Q* = *Q₋*** ist.

Somit können der Alterungszustand mittels SOH = (*Q*₊ + *Q₋*)/*Q* und der Ladezustand mittels SOC = *Q*₋/(*Q*₊ + *Q*₋) ermittelt werden.

Mit anderen Worten können über die genannten Ladungen der Ladezustand und/oder der Alterungszustand der Batteriezelle ermittelt werden. Allerdings ist das messtechnische Erfassen der genannten Ladung während eines Betriebs der Batteriezelle nicht unmittelbar möglich. Das vorliegende und im Folgenden beschriebene Verfahren ermöglicht jedoch eine Ermittlung während des Betriebs.

In einem ersten Schritt S1 des Verfahrens wird ein erster funktionaler Zusammenhang *V*(*Q*₊, *Q₋*) für eine Ruhespannung der Batteriezelle bereitgestellt.

Die Ruhespannung einer Batteriezelle ist eine zentrale Messgröße, die grundsätzlich Rückschlüsse auf die Ladezustände ermöglicht. Die Ruhespannung kann beispielsweise aus der Potentialdifferenz zwischen den beiden Elektroden durch *V*(*Q*₊, *Q₋*) = *V*₊(*Q*₊) - *V*₋(*Q*₋) ermittelt werden. Hierbei können die Abhängigkeiten der Elektrodenspannungen durch jeweilige Spannungskennlinien *V*₊(*Q*₊)*, V₋*(*Q₋*) gegeben sein.

In einem zweiten Schritt S2 des Verfahrens wird ein zweiter funktionaler Zusammenhang *D*(*Q*₊, *Q₋, Q*₀) für eine Ausdehnung der Batteriezelle bereitgestellt.

Hierbei ist ein Grundgedanke der Erfindung, dass für die Ermittlung der drei unbekannten Ladungen, die für das Bestimmen des Ladezustandes und/oder des Alterungszustandes erforderlich sind, drei unabhängige physikalische Messgrößen erforderlich sind. Hierbei hat sich gezeigt, dass die Ausdehnung der Batteriezelle in besonders vorteilhafterweise mit den Ladungen in Zusammenhang steht und zudem während des Betriebs der Batteriezelle erfassbar ist.

Mit anderen Worten wird eine zur Ruhespannung weitere physikalische Größe verwendet, welche mit der gespeicherten Ladung korreliert. Hierbei wird bei für das Verfahren besonders vorteilhaften Batterietypen die Ladung mittels aktiven und/oder inaktiven Materialien gespeichert. Dadurch dehnen sich die Elektroden aufgrund ihrer Zusammensetzung typischerweise bei der Aufnahme von Ladung aus beziehungsweise kontrahieren bei der Abgabe von Ladung. Hierdurch kommt es zur Volumenänderung (Ausdehnung) der Elektrode, welche sich auf eine Volumenänderung der Batteriezelle und/oder eine Änderung des Drucks in der Batteriezelle überträgt. Somit ist die Ausdehnung in Form einer Volumenänderung und/oder Drucks beziehungsweise einer Druckänderung eine messbare Größe, welche verwendet wird, um die gespeicherte Ladung der Batteriezelle zu bestimmen. Für mehrere Batterietypen, insbesondere für Lithium-Ionen-Batterien, kann mittels Dilatometern die Ausdehnung erfasst und mit der in der Batterie gespeicherten Ladung korreliert werden.

Mit anderen Worten kann die momentane Ausdehnung der Batteriezelle während des Betriebs der Batteriezelle, beispielsweise durch Verwendung eines Dilatometers, von Dehnungsmessstreifen, und/oder anderen Prinzipien auf Zellebene, Modulebene und/oder Systemebene. Weiterhin kann die Ausdehnung auch indirekt über Druckmessungen und/oder Kraftmessungen erfasst werden.

Die Ausdehnung kann über elektrodenspezifische und/oder materialspezifische Ausdehnungskennlinien erfasst werden. Mit anderen Worten ist *D*(*Q*₊*, Q₋, Q*₀) = *D*₊(*Q*₊) + *D₋*(*Q₋*) + *Dₒ*(*Qₒ*)*,* wobei *D*₊(*Q*₊) eine Ausdehnungskennlinie der ersten Elektrode (positive Elektrode), *D₋*(*Q*₋) eine Ausdehnungskennlinie der zweiten Elektrode (negative Elektrode) und *Dₒ*(*Qₒ*) eine Ausdehnungskennlinie bezüglich der inaktiven Ladung *Q*₀ bezeichnet.

Die bereitgestellte Abhängigkeit beziehungsweise funktionalen Zusammenhänge können eine Temperaturabhängigkeit berücksichtigen. In diesem Fall wird weiterhin eine Temperatur der Batteriezelle als weitere Messgröße erfasst und die Abhängigkeiten entsprechend korrigiert.

In einem dritten Schritt S3 des Verfahrens wird ein Messwert ***V*** der Ruhespannung erfasst.

Dies kann beispielsweise mittels bekannten Verfahren, das heißt grundsätzlich über Messungen von Spannungen und/oder Strömen erfolgen.

In einem vierten Schritt S4 des Verfahrens wird ein Messwert ***D*** der Ausdehnung erfasst.

Dies kann beispielsweise mittels eines Dilatometers, mittels Dehnungsstreifen und/oder weiteren bekannten Verfahren auf Zellebene, Modulebene und/oder Systemebene erfolgen. Weiterhin kann die Ausdehnung mittels einer Druckmessung und/oder Kraftmessung erfasst werden.

Gemäß einem fünften Schritt S5 des Verfahrens wird wenigstens der Ladezustand **SOC** und/oder der Gesundheitszustand **SOH** durch ein Lösen des Gleichungssystems *V* = *V*(*Q*₊, *Q₋*)*, D* = *D*(*Q*₊, *Q₋, Q*₀) und *Q* = *Q*₊ + *Q₋* + *Q*₀ ermittelt.

Das Ermitteln des Ladezustandes ist beispielsweise mittels des Zusammenhangs SOC = *Q₋*/(*Q*₊ + *Q*₋) möglich. Das Ermitteln des Gesundheitszustandes ist beispielsweise mittels SOH = (*Q*₊ + *Q*₋)/*Q* möglich. Die drei Ladungen beziehungsweise Ladungswerte beziehungsweise Kapazitäten können aufgrund der drei unabhängigen Gleichungen *V* = *V*(*Q*₊*, Q₋*)*, D* = *D*(*Q*₊*, Q₋, Q*₀) und *Q* = *Q*₊ + *Q*₋ + ***Q*₀** typischerweise eindeutig ermittelt werden. Dies kann computergestützt erfolgen.

Beispielsweise kann aus der Messung der Ausdehnung *D* **=** *D*(*Q*₊*, Q₋, Q*₀) = *D*₊(*Q*₊) + *D₋*(*Q₋*) + *Dₒ*(*Qₒ*) die inaktive Ladung *Q*₀ in Abhängigkeit der weiteren Ladungen *Q*₊ und *Q*₋ ermittelt werden. Mit anderen Worten gilt nach der Messung der Ausdehnung ***Q*₀ = *F*(*Q*₊*, Q₋*|*D*)***,* wobei ***F*** den funktionalen Zusammenhang bezeichnet. Da die nominelle Kapazität ***Q*** typischerweise bekannt ist, beispielsweise durch Herstellerangaben, kann mittels ***Q*** = *Q*₊ + *Q₋* + *Q*₀ die negative Ladung in Abhängigkeit der positiven Ladung ermittelt werden. Mit anderen Worten ist *Q₋* = *G*(*Q₊*|*D, Q*)*,* wobei *G* ≠ *F* wiederum den funktionalen Zusammenhang bezeichnet. Mittels des Messwertes der Ruhespannung ***V*** und des bereitgestellten Zusammenhangs kann schließlich die Abhängigkeit der negativen Ladung von der positiven Ladung eliminiert werden, sodass *Q₋* = *H*(*D, Q, V*) ist, wobei *H* ≠ *G* ≠ *F* wiederum den funktionalen Zusammenhang bezeichnet. Somit ist ***Q*₋** durch die erfassten Messwerte ***D*** und ***V*** sowie die bekannte nominelle Kapazität ***Q*** ermittelt. Durch Einsetzen des ermittelten Wertes der negativen Ladung in die weiteren Zusammenhänge lassen sich in analogerweise die weiteren Ladungen ***Q*₊** und ***Q*₀** ermitteln. Mittels den ermittelten Ladungen können dann der Ladezustand und/oder der Alterungszustand der Batteriezelle ermittelt werden.

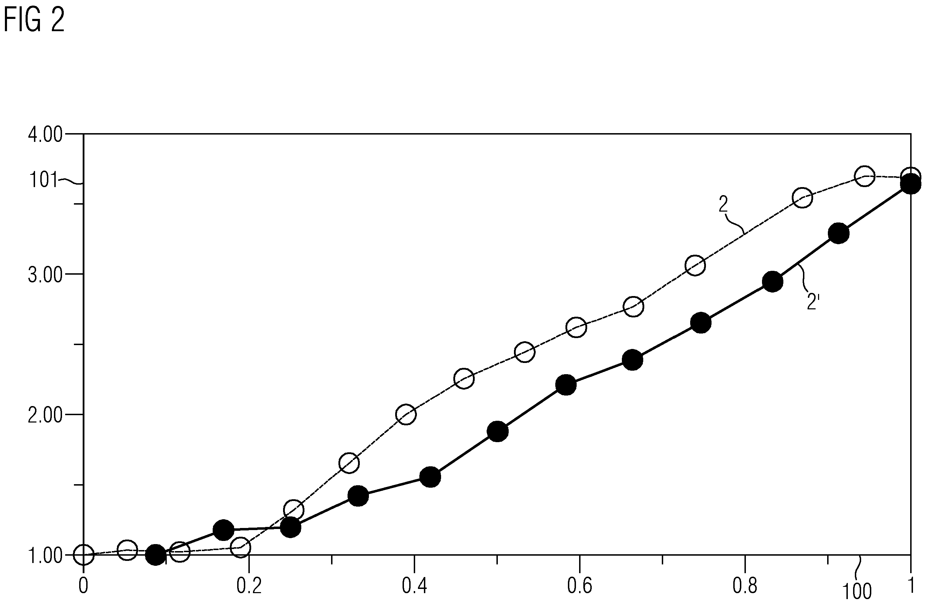

Die Figur 2 zeigt eine erste Kennlinie bezüglich einer Ausdehnung einer Batteriezelle. Hierbei umfasst eine Elektrode der Batteriezelle Silizium und es ist lediglich die Ausdehnung des Materials Silizium dargestellt.

An einer Abszisse 100 des Diagramms ist ein Ladezustand der Batteriezelle beziehungsweise der Komponente/Elektrode aufgetragen. An einer Ordinate 101 des Diagramms ist die Ausdehnung, vorliegend in Form eines auf ein ursprüngliches Volumen normiertes Volumen, Vol/Volᵢₙᵢₐₗ (Ausdehnung = Vol/Volᵢₙᵢₐₗ), aufgetragen.

Die Ausdehnung beziehungsweise Ausdehnungskennlinie 2 wurde bei einem Laden der Batteriezelle erfasst. Die Ausdehnung beziehungsweise die Ausdehnungskennlinie 2' wurde beim Entladen der Batteriezelle erfasst. Es zeigt sich für beide Ausdehnungskennlinien 2, 2' eine im Wesentlichen lineare Abhängigkeit. Dieser Zusammenhang kann, ebenfalls im nichtlinearen Fall, durch eine Fitfunktion, approximiert werden. Dadurch ist die Abhängigkeit der Ausdehnung von der Ladung beziehungsweise äquivalent vom Ladezustand der jeweiligen Batteriekomponente bestimmt. Die derart vorab bestimmte Abhängigkeit kann für das erfindungsgemäße Verfahren und/oder einer seiner Ausgestaltungen bereitgestellt werden.

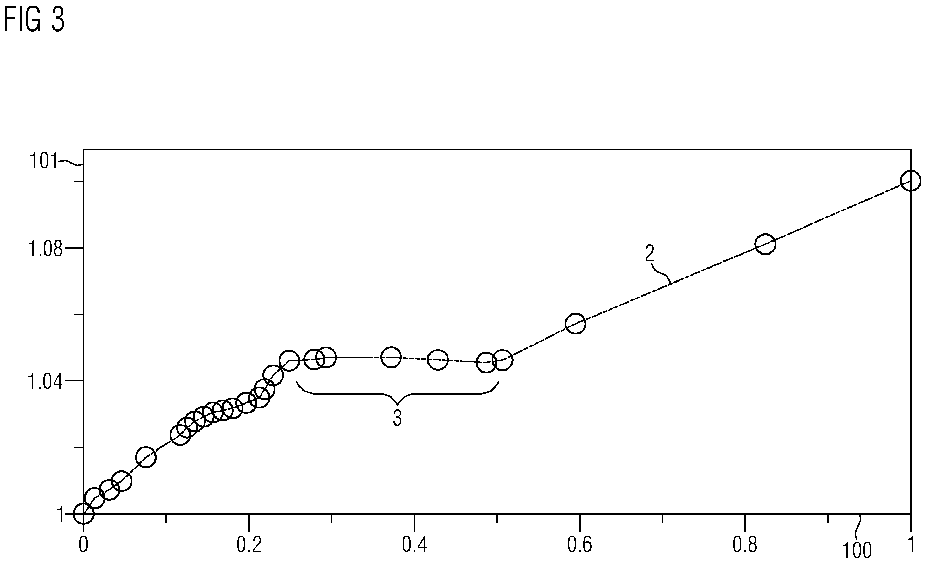

Die Figur 3 zeigt - analog zur Figur 2 - eine zweite Kennlinie bezüglich einer Ausdehnung einer Batteriezelle. Hierbei umfasst eine Elektrode der Batteriezelle Grafit und es ist lediglich die Ausdehnung des Materials Grafit dargestellt.

An einer Abszisse 100 des Diagramms ist ein Ladezustand der Batteriezelle beziehungsweise der Komponente aufgetragen. An einer Ordinate 101 des Diagramms ist die Ausdehnung, vorliegend in Form eines auf ein ursprüngliches Volumen normiertes Volumen, **Vol/Volᵢₙᵢₐₗ** (Ausdehnung = **Vol/Volᵢₙᵢₐₗ**), aufgetragen.

Die Ausdehnungskennlinie 2 von Grafit zeigt im Gegensatz zur Ausdehnungskennlinie von Silizium ein Plateau 3, das einem Phasenübergang 3 des Grafits (2L → 2) entspricht. Außerhalb des Plateaus 3 ist der Zusammenhang zwischen Ausdehnung und Kapazität beziehungsweise Ladung wiederum im Wesentlichen linear. Dieser Zusammenhang kann, ebenfalls im nichtlinearen Fall, durch eine Fitfunktion, approximiert werden. Dadurch ist die Abhängigkeit der Ausdehnung von der Ladung beziehungsweise äquivalent vom Ladezustand der jeweiligen Batteriekomponente bestimmt. Die derart vorab bestimmte Abhängigkeit kann für das erfindungsgemäße Verfahren und/oder einer seiner Ausgestaltungen bereitgestellt werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- S1: erster Schritt
- S2: zweiter Schritt
- S3: dritter Schritt
- S4: vierter Schritt
- S5: fünfter Schritt
- 2: Ausdehnungskennlinie (Laden)
- 2': Ausdehnungskennlinie (Entladen)
- 3: Phasenübergang
- 100: Abszisse
- 101: Ordinate

## Patentansprüche

1. Verfahren zur Ermittlung eines Ladezustandes **SOC** und/oder eines Gesundheitszustandes **SOH** einer Batteriezelle mit einer nominellen Ladung ***Q*,** wobei die nominelle Ladung ***Q*** eine Ladung ***Q*₊** einer ersten Elektrode und eine Ladung *Q₋* einer zweiten Elektrode der Batteriezelle sowie eine inaktive Ladung ***Q*₀** der Batteriezelle umfasst, **gekennzeichnet durch** die Schritte:
- (S1) Bereitstellen eines ersten funktionalen Zusammenhangs *V*(*Q*₊, *Q₋*) für eine Ruhespannung der Batteriezelle;
- (S2) Bereitstellen eines zweiten funktionalen Zusammenhangs *D*(*Q*₊, *Q₋, Q*₀) für eine Ausdehnung der Batteriezelle;
- (S3) Erfassen eines Messwertes ***V*** der Ruhespannung;
- (S4) Erfassen eines Messwertes ***D*** der Ausdehnung; und
- (S5) Ermitteln des Ladezustandes **SOC** und/oder des Gesundheitszustandes **SOH durch** ein Lösen des Gleichungssystems ***V* =** *V*(*Q*₊*, Q₋*)*, D* = *D*(*Q*₊, *Q₋, Q*₀) und *Q* = *Q*₊ + *Q*₋ + *Q*₀.

2. Verfahren gemäß Anspruch 1, **gekennzeichnet dadurch, dass** zum Ermitteln des Ladezustandes SOC und/oder des Gesundheitszustandes SOH die Ladungen *Q₊, Q₋* und/oder *Q*₀ durch ein Lösen des Gleichungssystems *V* = *V*(*Q*₊*, Q₋*)*, D*(*Q*₊*, Q₋, Q*₀) und *Q* = *Q*₊ + *Q₋* + *Q*₀ ermittelt werden.

3. Verfahren gemäß Anspruch 2, **gekennzeichnet dadurch, dass** der Ladezustand SOC mittels SOC = *Q₋*/*(Q*₊ + *Q₋*) ermittelt wird.

4. Verfahren gemäß Anspruch 2 oder 3, **gekennzeichnet dadurch, dass** ein Gesundheitszustand **SOH** der Batteriezelle durch **SOH = (*Q*₊ + *Q*₋)/*Q*** ermittelt wird.

5. Verfahren gemäß Anspruch 4, **gekennzeichnet dadurch, dass** eine zeitliche Änderungsrate des Gesundheitszustandes **SOH** ermittelt wird, und mittels der Änderungsrate eine Alterungsrate der Batteriezelle bestimmt wird.

6. Verfahren gemäß einem der vorhergehenden Ansprüche, **gekennzeichnet dadurch, dass** der erste funktionale Zusammenhang durch *V*(*Q*₊, *Q₋*) = *V*₊(*Q*₊) - *V*₋(*Q*₋) bereitgestellt wird, wobei *V*₊(*Q*₊) eine Spannungskennlinie der ersten Elektrode und V₋(Q₋) eine Spannungskennlinie der zweiten Elektrode ist.

7. Verfahren gemäß einem der vorhergehenden Ansprüche, **gekennzeichnet dadurch, dass** der zweite funktionale Zusammenhang durch ***D*(*Q*₊*, Q₋, Q*₀) = *D*₊(*Q*₊) + *D₋*(*Q₋*) + *Dₒ*(*Qₒ*)** bereitgestellt wird, wobei ***D*₊(*Q*₊)** eine Ausdehnungskennlinie (2, 2') der ersten Elektrode, *D*₋(*Q*₋) eine Ausdehnungskennlinie (2, 2') der zweiten Elektrode und ***Dₒ*(*Qₒ*)** eine Ausdehnungskennlinie (2, 2') bezüglich der inaktiven Ladung ***Q*₀** ist.

8. Verfahren gemäß Anspruch 6 oder 7, **gekennzeichnet dadurch, dass** eine Temperatur der Batteriezelle erfasst wird, und die jeweiligen Kennlinien die Abhängigkeit von der erfassten Temperatur berücksichtigen.

9. Verfahren gemäß einem der Ansprüche 6 bis 8, **gekennzeichnet dadurch, dass** die Kennlinien in Abhängigkeit der jeweiligen Stoffzusammensetzung, insbesondere der Elektroden, bereitgestellt werden.

10. Verfahren gemäß einem der Ansprüche 6 bis 9, **gekennzeichnet dadurch, dass** die Kennlinien in Abhängigkeit des Typs der Batteriezelle bereitgestellt werden.

11. Verfahren gemäß einem der vorhergehenden Ansprüche, **gekennzeichnet dadurch, dass** der Messwert ***D*** der Ausdehnung mittels eines Dilatometers, einer Kraftmessung, einer Druckmessung und/oder mittels Dehnungsmessstreifen erfasst wird.

12. Verfahren gemäß einem der vorhergehenden Ansprüche, **gekennzeichnet dadurch, dass** die Ermittlung des Ladezustandes **SOC** und/oder des Gesundheitszustandes **SOH** während eines Betriebs der Batteriezelle erfolgt.

13. Batteriemanagementsystem für eine Batteriezelle, **dadurch gekennzeichnet, dass** dieses ausgebildet ist, einen Ladezustand **SOC** und/oder einen Gesundheitszustand **SOH** der Batteriezelle nach einem Verfahren gemäß einem der vorhergehenden Ansprüche zu ermitteln.

14. Batteriezelle oder Batterie, **dadurch gekennzeichnet, dass** diese ein erfindungsgemäßes Batteriemanagementsystem gemäß Anspruch 13 umfasst.
